# EUROPÄISCHE PATENTSCHRIFT

(11) **EP 1 045 478 B1**
(45) Veröffentlichungstag und Bekanntmachung des Hinweises auf die Patenterteilung: **07.12.2011**
(21) Anmeldenummer: 99107645.6
(22) Anmeldetag: 16.04.1999
(51) Int. Cl.: H01R 12/71

(54) **Elektrisches Gerät**
Electrical device
Appareil électrique

(43) Veröffentlichungstag der Anmeldung: 18.10.2000
(73) Patentinhaber: Continental Automotive GmbH, 30165 Hannover (DE)
(72) Erfinder: Warnan, François, 78 120 Rambouillet (FR)

(56) Entgegenhaltungen:
- EP-A- 0 822 621
- EP-A- 0 892 477
- DE-A- 4 014 250
- FR-A- 2 686 462
- US-A- 4 820 172
- US-A- 4 936 787

## Beschreibung

Die Erfindung betrifft ein elektrisches Gerät, insbesondere Autoradio, mit einer innerhalb eines Gerätegehäuses sich in Haupterstreckungsebene des Gerätes erstreckenden Leiterplatte und einer auf der Leiterplatte befestigten Steckeraufnahme, welche rückseitig aus der Steckeraufnahme herausgeführte Kontaktteile aufweist, die mit Leiterbahnen der Leiterplatte Verbindung haben.

Solche elektrische Geräte werden derzeit als Autoradio in nahezu jedes Kraftfahrzeug eingebaut und sind deshalb allgemein bekannt. Die Steckeraufnahme ist dabei im rückwärtigen Bereich des Gerätegehäuses so angeordnet, dass man den Stecker mit den elektrischen Anschlüssen horizontal von hinten her in die Steckeraufnahme einschieben muss. Hierzu ist es erforderlich, dass die meist als Kontaktstifte oder Kontaktfahnen ausgebildeten Kontaktteile der Steckeraufnahme parallel zur Leiterplatte nach hinten ausgerichtet sind. Ihre aus dem Steckergehäuse rückseitig herausführenden Enden haben daher unterschiedlichen Abstand von der Leiterplatte. Deshalb verbindet man diese Enden mit einer stehend auf der Leiterplatte angeordneten, zusätzlichen Leiterplatte. Diese zusätzliche Leiterplatte. Diese zusätzliche Leiterplatte ist ihrerseits elektrisch mit der eigentlichen Leiterplatte verbunden.

Die bekannte Art der Anordnung und Befestigung der Steckeraufnahme ist relativ aufwendig, weil sie eine zusätzliche Leiterplatte erfordert und eine relativ große Anzahl elektrischer Verbindungen herzustellen ist. Die relativ langen elektrischen Wege wirken sich bei einem Radio nachteilig auf, da dadurch ein Antenneneffekt entsteht und weil sich generell durch die in diesem Bereich verlaufenden Leitungen die elektromagnetische Verträglichkeit solcher Geräte vermindert.

Die EP-A-0892477 offenbart einen Anschlusskasten für ein Autoradio zur Befestigung an einer winkeligen. Ausnehmung des Autoradiogehäuses, an dessen winkelig zueinander stehenden Wandabschnitten der Anschlusskasten mit einer bereiten Seite und einer schmalen Seite anliegt, wobei Bodenkontakte des Anschlusskastens in Anschlusskontakten des Autoradios außerhalb des Autoradiogehäuses durch eine Einschubbewegüng in Richtung des Bodens kontaktierbar sind. Gemäß EP-A-0892477 ist sind ein Haltewinkel zum Übergreifen der oberseiten und Anliegen auf der Innenseite der Wandabschnitte des Autotradiogehäuses vorgesehen und es ist vorgesehen das wenigstens eine Seite des Anschlusskastens mit wenigstens einer Arretierungsfeder versehen ist, die zum Arretieren entgegen der Einschubbewegung durch Einrasten in eine zugehörige Ausnehmung in dem betreffenden Wandabschnitt am Ende der Einschubbewegung ausgebildet ist.

Die US-A-4936787 offenbart einen Anschluss für ein Fahrzeugradio, das ein Gehäuse mit einer oberen Platte, einer unteren Platte und Seitenplatten aufweist, wobei in dem Gehäuse eine Leiterplatte auf Höhe der unteren Platte gesichert angeordnet wird und mindestens einen elektrischen Anschluss aufweist. Eine der Seiteplatten weißt eine Blendenöffnung, die den elektrischen Anschluss aufnimmt, auf. Es wird in der Druckschrift eine Schnittstelle offenbart, die gesichert lösbar an dem Gehäuse angebracht wird, und den elektrischen Anschluss durch die Blendenöffnung durch kontaktiert, um eine elektrische Verbindung zwischen einen externen Objekt und und dem elektrischen Anschluss herzustellen.

Der Erfindung liegt das Problem zugrunde, ein elektrisches Gerät der eingangs genannten Art so auszubilden, dass seine Steckeraufnahme mit möglichst geringem Aufwand ist.

Dieses Problem wird erfindungsgemäss dadurch gelost, dass die Steckeraufnahme mit ihrer Rückseite auf der Leiterplatte stehend angeordnet ist und die Kontaktteile unmittelbar Verbindung mit den Leiterbahnen der Leiterplatte haben.

Durch diese Gestaltung entfällt das Erfordernis einer stehend auf der Leiterplatte anzuordnenden Hilfsleiterplatte, wodurch sich eine wesentliche Kostenersparnis ergibt. Gleichzeitig werden die erforderlichen elektrischen Verbindungen kurzer, was die Montagekosten senkt, die Gefahr von Fertigungsmängeln vermindert, zu einer besseren elektromagnetischen Verträglichkeit des Gerätes beiträgt sowie unerwünschte Antenneneffekte verhindert. Weiterhin ist die Kabelzuführung für das erfindungsgemässe Gerät vielfach günstiger, weil oftmals hinter solchen Geräten der Platz beengter ist als oberhalb oder unterhalb des Gerätes und das erfindungsgemäße Gerät eine Kabelführung von oben oder unten erlaubt.

Konstruktiv besonders einfach ist das erfindungsgemäße, elektrische Gerät ausgebildet, wenn das Gerätegehäuse an einer rückwärtigen Ecke eine Aussparung aufweist, in welche hinein die Leiterplatte mit der darauf angeordneten Steckeraufnahme ragt.

Wenn die Steckeraufnahme eine größere Anzahl elektrischer Kontakte hat, dann kann man gemäß einer vorteilhaften Weiterbildung der Erfindung vorsehen, dass die Leiterplatte mit einem Ansatz aus dem Gerätegehäuse herausgeführt ist und dort die Steckeraufnahme aufweist.

Die Erfindung lässt verschiedene Ausführungsformen zu. Zur weiteren Verdeutlichung ihres Grundprinzips ist eine davon in der Zeichnung dargestellt und wird nachfolgend beschrieben. Die Zeichnung zeigt in
- Fig.1: eine perspektivische Darstellung eines als Autoradio ausgebildeten elektrischen Gerätes,
- Fig.2: einen Schnitt durch einen Teilbereich einer Leiterplatte des Gerätes mit einer darauf be- festigten Steckeraufnahme,
- Fig.3: eine Draufsicht auf die Leiterplatte im Be- reich der noch nicht montierten Steckerauf- nahme,
- Fig.4: eine der Figur 3 entsprechende, abgewandelte Ausführungsform der Leiterplatte.

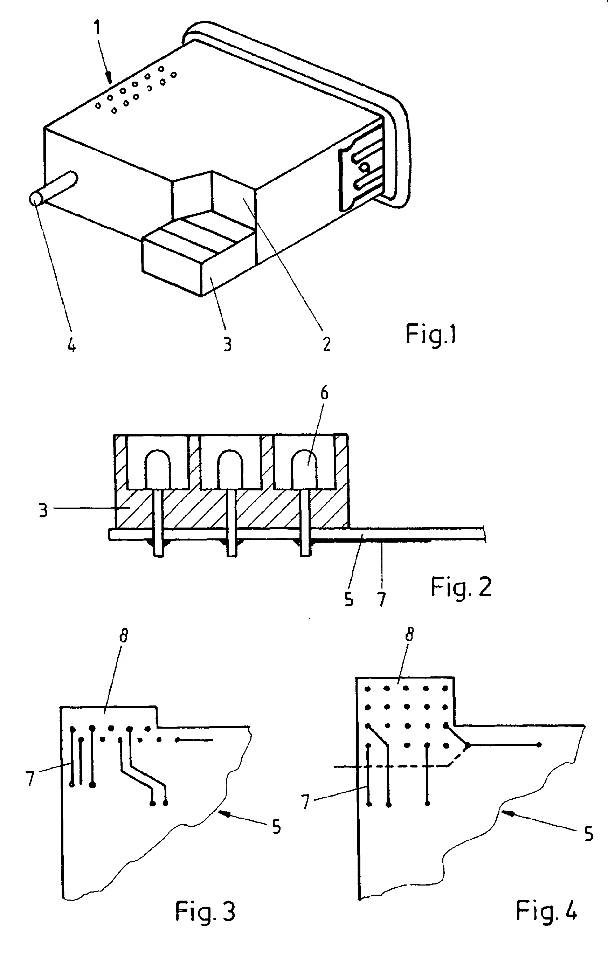

Die Figur 1 zeigt von einem Autoradio ein Gerätegehäuse 1, welches in seiner von vorn gesehen linken, rückwärtigen Ecke eine Aussparung 2 hat, in der eine Steckeraufnahme 3 angeordnet ist. Ein nicht dargestelltes Kabel wird deshalb mit einem ebenfalls nicht gezeigten Stecker von oben her in die Steckeraufnahme 3 gesteckt, um die erforderlichen elektrischen Verbindungen herzustellen. An der der Aussparung 2 gegenüberliegenden Ecke des Gerätegehäuses 1 erkennt man einen üblichen Antennenanschluss 4.

In Figur 2 ist teilweise eine Leiterplatte 5 dargestellt, die in Haupterstreckungsrichtung des Gerätegehäuses 1 innerhalb des Gerätegehäuses 1 angeordnet ist und in die Aussparung 2 ragt. Auf dieser Leiterplatte 5 ist die Steckeraufnahme 3 stehend angeordnet. Die Steckeraufnahme 3 hat üblich ausgebildete Kontaktteile 6, welche rückseitig aus der Steckeraufnahme 3 herausgeführt sind, die Leiterplatte 5 durchdringen und jeweils mit einer Leiterbahn 7 verlötet sind.

Die Figuren 3 und 4 zeigen, dass die Leiterplatte 5 einen unterschiedlich weit vorspringenden Ansatz 8 haben kann, auf dem jeweils die Steckeraufnahme 3 zu montieren ist. Hierdurch kann man sich unterschiedlich großen Steckeraufnahmen 3 mit einer unterschiedlich hohen Zahl von Kontaktteilen anpassen. Je nach Ausführungsform des Gerätegehäuses 1 kann dieser Ansatz 8 dann mehr oder minder weit in die Aussparung ragen oder sogar über die Außenkontur des Gerätegehäuses 1 vorspringen.

## Patentansprüche

1. Elektrisches Gerät, insbesondere Autoradio, mit einer innerhalb eines Gerätegehäuses (1) sich in Haupterstreckungsebene des Gerätes erstreckenden Leiterplatte(5) und einer auf der Leiterplatte (5) befestigten Steckeraufnahme (3), welche rückseitig aus der Steckeraufnahme (3) herausgeführte Kontaktteile (6) aufweist, die mit Leiterbahnen der Leiterplatte (5) Verbindung haben und die Kontaktteile (6) der Steckeraufnahme (3) unmittelbar Verbindung mit den Leiterbahnen der Leiterplatte (5) haben, **dadurch gekennzeichnet, dass** die Steckeraufnahme (3) mit ihrer Rückseite auf der Leiterplatte (5) stehend angeordnet ist zur Einführung eines Steckers in die Steckeraufnahme (3) in Richtung der Leiterplatte (5).

2. Elektrisches Gerät nach Anspruch 1, **dadurch gekennzeichnet, dass** das Gerätegehäuse (1) an einer rückwärtigen Ecke eine Aussparung (2) aufweist, in welche hinein die Leiterplatte (5) mit der darauf angeordneten Steckeraufnahme (3) ragt.

3. Elektrisches Gerät nach den Ansprüchen 1 oder 2, **dadurch gekennzeichnet, dass** die Leiterplatte (5) mit einem Ansatz (8) aus dem Gerätegehäuse (1) herausgeführt ist und dort die Steckeraufnahme (3) aufweist.

## Claims

1. Electric appliance, in particular an automobile radio, with a printed board (5) extending in the plane of principal extent of the appliance within an appliance housing (1) and with a plug receptacle (3) which is fastened to the printed board (5) and has on the rear side, contact parts (6) led out of the plug receptacle (3) and connected to conductor tracks of the printed board (5), and the contact parts (6) of the plug receptacle (3) are directly connected to the conductor tracks of the printed board (5), **characterized in that** the plug receptacle (3) is arranged with its rear side standing on the printed board (5) for the insertion of a plug into the plug receptacle (3) in direction of the printed board (5).

2. Electric appliance according to Claim 1, **characterized in that** the appliance housing (1) has, at a rear corner, a recess (2), into which the printed board (5), together with the plug receptacle (3) arranged on it, projects.

3. Electric appliance according to Claim 1 or 2, **characterized in that** the printed board (5) is led with an extension (8) out of the appliance housing (1) and has the plug receptacle (3) there.

## Revendications

1. Appareil électrique, notamment autoradio, comprenant une plaquette à circuit imprimé (5) s'étendant à l'intérieur d'un boîtier (1) d'appareil dans le plan d'étendue principale du boîtier et un logement (3) de connecteur fixé sur la plaquette à circuit imprimé (5) et ayant du côté arrière des pièces (6) de contact qui sortent du logement (3) du connecteur et qui ont une liaison avec les pistes conductrices de la plaquette à circuit imprimé (5) et les pièces (6) de contact du logement (3) du connecteur ont directement une liaison avec les pistes conductrices de la plaquette à circuit imprimé (5), **caractérisé en ce que** le logement (3) du connecteur est disposé en ayant son côté arrière sur la plaquette du circuit imprimé (5) pour l'introduction d'un connecteur dans le logement (3) de connecteur dans la direction de la plaquette à circuit imprimé (5).

2. Appareil électrique suivant la revendication 1, **caractérisé en ce que** le boîtier (1) de l'appareil comporte sur un coin du côté arrière un évidement (2) dans lequel pénètre la plaquette à circuit imprimé (5) ayant le logement (3) du connecteur qui y est disposé.

3. Appareil électrique suivant la revendication 1 ou 2, **caractérisé en ce que** la plaquette à circuit imprimé (5) sort par une saillie (8) du boîtier (1) de l'appareil et y comporte le logement (3) du connecteur.
